Europäisches Patentamt

European Patent Office

Office européen des brevets

(11) Veröffentlichungsnummer : **0 190 407**
B1

# (12) EUROPÄISCHE PATENTSCHRIFT

(45) Veröffentlichungstag der Patentschrift :
17.05.89

(51) Int. Cl.⁴ : **H 02 B  1/10**, B 66 B  1/46,
H 05 K  7/14

(21) Anmeldenummer : 85114186.1

(22) Anmeldetag : 07.11.85

(54) Tableau für Aufzüge.

(30) Priorität : 06.02.85 CH 541/85

(43) Veröffentlichungstag der Anmeldung :
13.08.86 Patentblatt 86/33

(45) Bekanntmachung des Hinweises auf die Patenterteilung : 17.05.89 Patentblatt 89/20

(84) Benannte Vertragsstaaten :
AT CH DE FR GB IT LI

(56) Entgegenhaltungen :
CH–A–   539 378
US–A– 3 258 649

(73) Patentinhaber : INVENTIO AG
Seestrasse 55
CH-6052 Hergiswil NW (CH)

(72) Erfinder : Arato, Laszlo, Dipl.-Ing.
Seebuchtstrasse 19
CH-6374 Buochs (CH)
Erfinder : Borter, Ephraim, Ing. HTL
Fluhmattstrasse 6
CH-6033 Buchrain (CH)

**Beschreibung**

Die Erfindung betrifft ein Tableau für Aufzüge, mit einem Gehäuse, in welchem auf einer oder mehreren Montageplatten befestigte Schalter und Anzeigelampen für die Eingabe von Steuerbefehlen bzw. für die Anzeige gespeicherter Steuerbefehle angeordnet sind, wobei die Montageplatte(n) in einer Ebene liegend vom Gehäuse gehalten wird (werden), und wobei das Gehäuse zwei in Längsrichtung des Tableaus verlaufende Seitenwände aufweist.

Mit der CH-PS 539 378 ist ein solches Tableau bekannt geworden, bei dem das Gehäuse aus einem U-Profil besteht, dessen beide Schenkel Seitenwände bilden und dessen die Schenkel verbindender Teil als Frontplatte des Tableaus dient. Die Montageplatten, die in einer bevorzugten Ausführung gedruckte Schaltungen sind, liegen auf den Schenkeln auf und sind mittels Federn, die in an den Schenkeln vorgesehenen Nuten einrasten, schraubenlos mit diesen verbunden. Die auf den gedruckten Schaltungen befestigten Bedienungselemente ragen dabei durch entsprechend geformte Durchbrüche der Frontplatte. Derartige Tableaus sind normalerweise so eingebaut, dass sie nicht von hinten zugänglich sind. Sollen gegebenenfalls die Bedienungs- und Anzeigeelemente oder andere auf den gedruckten Schaltungen angeordnete Bauteile ausgewechselt werden, so muss das Tableau ausgebaut und die betreffende gedruckte Schaltung von den Schenkeln des Gehäuses abgezogen werden, ein Verfahren, das umständlich und zeitraubend ist.

Es ist daher Aufgabe der Erfindung, ein Tableau der eingangs genannten Art zu schaffen, bei dem die Montageplatten von der Frontseite aus eingesetzt und entfernt werden können, ohne dass das Tableau ausgebaut werden muss.

Diese Aufgabe wird durch die im Patentanspruch 1 gekennzeichnete Erfindung gelöst. Hierbei weist das Gehäuse an der Frontseite des Tableaus eine durchgehend offene Vorderseite auf, welche grösser als die Montageplatte(n) ist und durch aneinandergefügt angeordnete Abdeckhauben, sowie gegebenenfalls Blinddeckel und/oder Verschlußplatte(n) abdeckbar ist. Die Montageplatte(n) wird (werden) an ihren Rändern in Führungen gehalten, die in Nuten eingesetzt sind, welche an den Innenseiten der Seitenwände des Gehäuses vorgesehen sind. Dabei sind die Nuten derart angeordnet, dass Frontflächen von Abdeckhauben der Schalter und Anzeigelampen sowie gegebenenfalls Frontflächen von Blinddeckeln, Pfeiledeckplatten und Verschlussplatten mit frontseitigen Seiten-Flanschen des Gehäuses bündig sind und eine geschlossene, im wesentlichen ebene Frontfläche des Tableaus bilden.

Die mit der Erfindung erzielten Vorteile sind darin zu sehen, dass Servicearbeiten und Reparaturen einfacher und schneller durchgeführt werden können. Ein weiterer Vorteil liegt darin, dass das Tableau keine kommissionsabhängige Front- oder Abdeckplatte benötigt.

Im folgenden wird die Erfindung an Hand zweier auf der Zeichnung dargestellter Ausführungsbeispiele näher erläutert. Es zeigen :

Fig. 1 eine Ansicht des unteren Teiles eines Kabinentableaus,

Fig. 2 einen Schnitt des Kabinentableaus gemäss der Linie A-A der Fig. 1,

Fig. 3 einen Schnitt des Kabinentableaus gemäss der Linie B-B der Fig. 1,

Fig. 4 einen Schnitt des Kabinentableaus gemäss der Linie C-C der Fig. 1 in vergrössertem Massstab,

Fig. 5 einen Schnitt einer Montageplattenhalterung des Kabinentableaus gemäss der Linie A-A der Fig. 1 in vergrössertem Massstab,

Fig. 6 einen Schnitt der Montageplattenhalterung gemäss der Linie D-D der Fig. 5 in vergrössertem Massstab,

Fig. 7 eine Ansicht eines Stockwerktableaus und

Fig. 8 einen Schnitt des Stockwerktableaus gemäss der Linie E-E der Fig. 7 in vergrössertem Massstab.

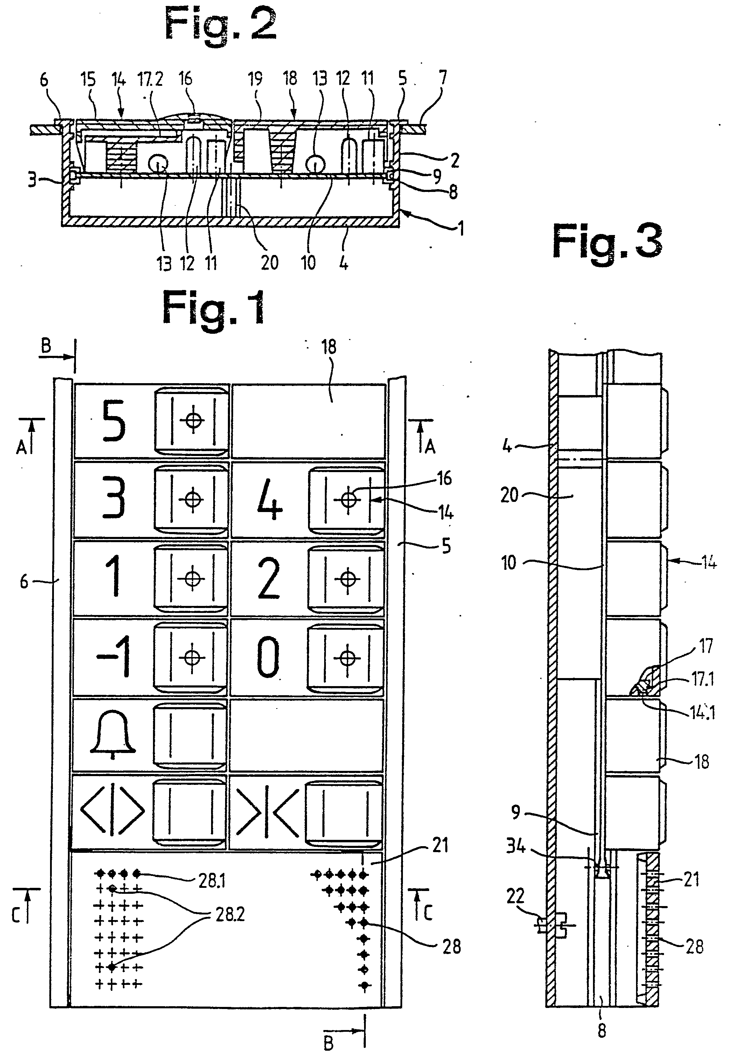

In den Fig. 1 bis 4 ist mit 1 ein Gehäuse bezeichnet, das beispielsweise aus einem U-Profil hergestellt ist, welches zwei in Längsrichtung des Kabinentableaus verlaufende Seitenwände 2, 3 und die Rückwand 4 des Gehäuses 1 bildet. An der Frontseite des Kabinentableaus ist das Gehäuse 1 durchgehend offen, wobei die frontseitigen Ränder der Seitenwände 2, 3 mit Seiten-Flanschen 5, 6 versehen sind, mit welchen das Gehäuse 1 auf einer Wand 7 einer Aufzugskabine aufliegt. An den Innenseiten der Seitenwände 2, 3 sind Nuten 8 vorgesehen, in welche Führungen 9 verschiebbar eingesetzt sind. Mit 10 sind Montageplatten, beispielsweise in Form von gedruckten Schaltungen, bezeichnet, die an ihren Rändern in den Führungen 9 gehalten werden. Auf den Montageplatten 10 sind Schalter 11 für die Eingabe von Steuerbefehlen und Anzeigelampen 12 für die Anzeige gespeicherter Steuerbefehle befestigt, wobei die Steuerbefehle beispielsweise Kabinenrufe und Türöffnungs- oder Türschliessbefehle sein können, und wobei jeweils den Schaltern 11 für die Eingabe von Kabinenrufen Anzeigelampen 12 zugeordnet sind. Als Schalter 11 und Anzeigelampen 12 sind vorzugsweise Mikroschalter und Leuchtdioden vorgesehen. Weitere, auf den Montageplatten 10 befestigte Bauelemente, beispielsweise Widerstände und Dioden, sind mit 13 bezeichnet. Die Schalter 11 und gegebenenfalls die zugehörigen Anzeigelampen 12 sowie die weiteren Bauelemente 13 sind mittels gleich grosser Abdeckhauben 14 abgedeckt, die aneinandergefügt auf den Montageplatten 10 angeordnet sind, wobei in Frontflächen 15 der jeweils betreffenden Abdeckhauben 14, Linsen 16 für die Anzeigelampen 12 eingesetzt sind. Die Abdeckhauben 14 sind begrenztschwenkbar an auf den Montageplatten 10 befestigten Trägern 17 gelagert und bilden in dieser Weise Betätigungsglieder der Schalter 11 in Form von Drucktasten. Hierbei sind in den vorzugsweise aus einem elastischen Kunststoff bestehenden Abdeckhauben 14 Löcher 14.1 vorgesehen, in welche Lagerzapfen 17.1 eingreifen, die an den ebenfalls aus einem elastischen Kunststoff bestehenden Trägern 17 federnd angebracht sind. Ein Teil des Trägers 17 ist als Rückstellfeder 17.2 ausgebildet, die bei Benutzung der Abdeckhaube 14 als Drucktaste die Rückstellbewegung des Schalters 11 unterstützt.

Weitere, gleich grosse Blinddeckel 18 sind fest mit den Montageplatten 10 verschraubt. Mit den weiteren Blinddeckeln 18 werden Schalter 11, Anzeigelampen 12 und weitere Bauelemente 13 ohne Funktion abgedeckt, die für einen späteren Ausbau der Aufzugsanlage vorgesehen sind. Die Nuten 8 sind derart an den Innenseiten der Seitenwände 2, 3 angeordnet, dass die Frontflächen 15 der Abdeckhauben 14 und Frontflächen 19 der weiteren Blinddeckel 18 mit den frontseitigen Seiten-Flanschen 5, 6 des Gehäuses 1 bündig sind und mit diesen eine geschlossene, im wesentlichen ebene Frontfläche des Kabinentableaus bilden.

Die Montageplatten 10 sind bo bemessen, dass sie von der Frontseite des Kabinentableaus aus in die Führungen 9 eingesetzt werden können. Gemäss den Fig. 1 bis 3 sind mehrere Schalter 11, Anzeigelampen 12 und Bauelemente 13 für eine entsprechende Anzahl Steuerbefehle in zwei Reihen auf einer einzigen Montageplatte 10 angeordnet. Die Montageplatte 10 stützt sich hierbei über eine Abstützung 20 auf der Rückwand 4 des Gehäuses 1 ab. Es ist natürlich auch möglich, die Schalter 11, Anzeigelampen 12 und Bauelemente 13 nur in einer Reihe anzuordnen, wobei die Abstützung 20 nicht erforderlich wäre. Es kann jedoch auch zweckmässig sein, mehrere, bezw. zusätzliche Montageplatten 10 zu verwenden, die jeweils nur mit Bauteilen 11, 12, 13 für einen Steuerbefehl bestückt sind.

Mit 21 ist eine Verschlussplatte bezeichnet, die der Abdeckung der Tableaubefestigungselemente, beispielsweise in Form von Schrauben 22, dient und die derart am Gehäuse 1 angeordnet ist, dass sie nicht ohne weiteres von unbefugten Personen entfernt werden kann. An der Verschlussplatte 21 sind Führungsnuten 21.1 vorgesehen, in welchen ein unter der Einwirkung einer Feder 23 stehender Riegel 24 verschiebbar geführt ist. An den Innenseiten der Seitenwände 2, 3 des Gehäuses 1 sind Nuten 25 vorgesehen, in welche an der Verschlussplatte 21 und am Riegel 24 angebrachte Vorsprünge 26, 27 beim Aufsetzen der Verschlussplatte 21 einrasten. Die Nuten 25 sind derart angeordnet, dass die Verschlussplatte 21 mit den frontseitigen Seiten-Flanschen 5, 6 des Gehäuses 1 bündig ist. In der Verschlussplatte 21 sind eine Anzahl gleich grosser, siebartig angeordneter Löcher 28 vorgesehen, die als Schallaustrittsöffnungen eines im Bedarfsfalle unter der Verschlussplatte 21 angeordneten Lautsprechers dienen, und von denen einige im Bereiche des Riegels 24 beispielsweise als Sacklöcher 28.1 ausgebildet sind. Der Riegel 24 weist zwei mit Abschrägungen 30 versehene Öffnungen 29 auf, die mit zwei der Löcher 28 korrespondieren, welche als Schlüsselöffnungen 28.2 dienen. Mit 31 ist ein Gabelzinken eines gabelartig ausgebildeten Schlüssels bezeichnet, der eine Abschrägung 32 aufweist, die beim Entfernen der Verschlussplatte 21 mit der Abschrägung 30 der Öffnung 29 zusammenwirkt.

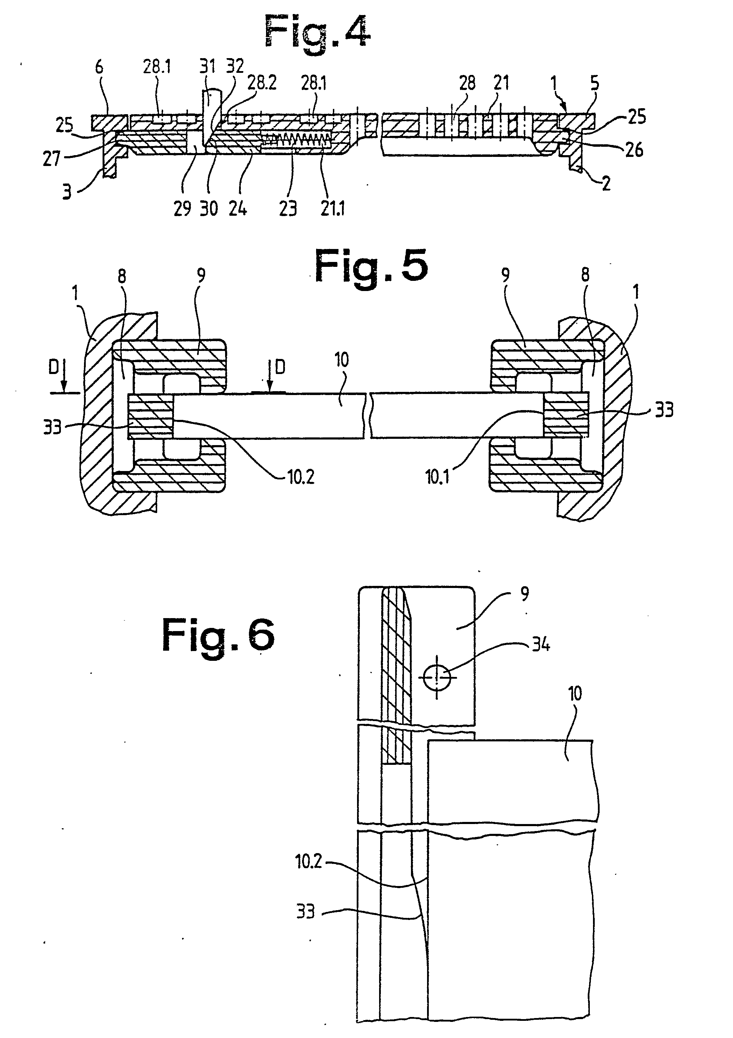

Gemäss Fig. 5 und 6 weisen die vorzugsweise aus einem elastischen Kunststoff bestehenden Führungen 9 einen C-profilartigen Querschnitt auf, der so bemessen ist, dass die Ränder der Montageplatten 10 zangenartig federnd umfasst werden. An den Führungen 9 sind federnde Nocken 33 vorgesehen, die auf Stirnseiten 10.1, 10.2 der Montageplatte 10 drücken. Auf diese Weise können die Montageplatten 10 trotz möglicherweise einseitig auftretender Toleranzfehler sowohl in Richtung der Frontseite des Tableaus als auch quer dazu form- und kraftschlüssig gehalten werden. An den Enden der Führungen 9 sind Löcher 34 vorgesehen, die zur Aufnahme eines Werkzeuges zwecks Verschiebung der Führungen 9 in den Nuten 8 bestimmt sind. Nach Entfernung der Verschlussplatte 21 und Verschiebung mindestens einer Führung 9 können daher die Montageplatten 10 von der Frontseite des Tableaus aus eingesetzt oder herausgenommen werden.

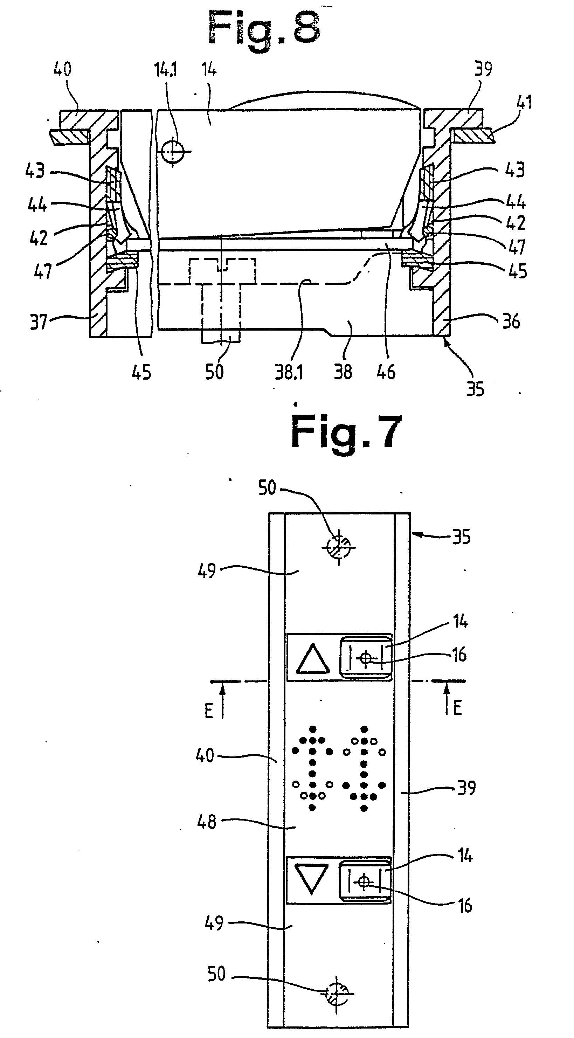

In den Fig. 7 und 8 ist mit 35 ein Gehäuse bezeichnet, das aus zwei in Längsrichtung des Stockwerktableaus verlaufende, Seitenwände 36, 37 bildende Profilschienen besteht, die an ihren Enden mittels winkelförmiger Endstücke 38 miteinander verbunden sind, deren parallel zur Frontseite des Stockwerktableaus verlaufende Schenkel Befestigungsflansche 38.1 des Stockwerktableaus bilden. An den Seitenwänden 36, 37 sind frontseitig Seiten-Flansche 39, 40 vorgesehen, mit welchen das Gehäuse 35 auf einer Wand oder einem Stockwerktürpfosten 41 aufliegt. An den Innenseiten der Seitenwände 36, 37 sind Nuten 42 angeordnet, in welche Führungen 43 eingesetzt sind. Die Führungen 43 bestehen vorzugsweise aus einem elastischen Kunststoff und weisen federnde Rasthebel 44 und eine Auflageleiste 45 auf. Beim Einsetzen einer Montageplatte 46 von der Frontseite des Tableaus aus, rasten deren Ränder in die Führungen 43 ein und werden zwischen den Rasthebeln 44 und den Auflageleisten 45 form- und kraftschlüssig gehalten. Zwischen den Rasthebeln 44 und den Innenseiten der Seitenwände 36, 37 sind in Längsrichtung des Tableaus verlaufende und verschiebbare Verriegelungsstangen 47 vorgesehen, mittels welchen die Rasthebel 44 bei Bedarf blockierbar sind, so dass die Montageplatte 46 nicht entfernt werden kann. Die Montageplatte 46 trägt die Schalter 11, Anzeigelampen 12 und weiteren Bauelemente 13 (Fig. 1 bis 3) sowie die entsprechenden, als Drucktasten dienenden Abdeckhauben 14 für die Steuerbefehle « AUF » und « AB ». Ausserdem sind noch weitere, nicht dargestellte Anzeigelampen und Bauelemente für die Weiterfahrtsignalisation vorgesehen und mittels einer Pfeiledeckplatte 48 abgedeckt. Die Nuten 43 sind derart angeordnet, dass die Frontflächen der Abdeckhauben 14 und der Pfeiledeckplatte 48 mit den frontseitigen Seiten-Flanschen E39, 40 des Gehäu-uses 35 bündig sind und mit diesen eine im wesentlichen ebene Frontfläche des Stockwerktableaus bilden.

Mit 49 sind Verschlussplatten bezeichnet, die ähnlich der Verschlussplatte 21 gemäss den Fig. 1, 3, 4 der Abdeckung der Tableaubefestigungselemente, beispielsweise in Form von Schrauben 50, dienen. Auch die Verschlussplatten 49 sind derart am Gehäuse 35 angeordnet, dass sie mit den frontseitigen Seiten-Flanschen 39, 40 bündig sind und von unbefugten Personen nicht ohne weiteres entfernt werden können. Nach Entfernung der Verschlussplatten 49 und gegebenenfalls Verschiebung der Verriegelungsstangen 47 kann die Montageplatte 46 von der Frontseite des Tableaus aus eingesetzt oder herausgenommen werden.

**Patentansprüche**

1. Tableau für Aufzüge, mit einem Gehäuse (1 bzw. 35), in welchem auf einer oder mehreren Montageplatten (10 bzw. 46) befestigte Schalter (11) und Anzeigelampen (12) für die Eingabe von Steuerbefehlen bzw. für die Anzeige gespeicherter Steuerbefehle angeordnet sind, wobei die Montageplatte(n) (10 bzw. 46) in einer Ebene liegend vom Gehäuse (1 bzw. 35) gehalten wird (werden), und wobei das Gehäuse (1 bzw. 35) zwei in Längsrichtung des Tableaus verlaufende Seitenwände (2, 3 bzw. 36, 37) aufweist, dadurch gekennzeichnet,
— dass das Gehäuse (1 bzw. 35) an der Frontseite des Tableaus eine durchgehend offene Vorderseite aufweist, welche grösser als die Montageplatte(n) (10 bzw. 46) ist, und durch aneinandergefügt angeordnete Abdeckhauben (14) sowie gegebenenfalls Blinddeckel (18) und/oder Verschlussplatte(n) (21 bzw. 49) abdeckbar ist, und
— dass die Montageplatte(n) (10 bzw. 46) an ihren Rändern in Führungen (9 bzw. 43) gehalten wird (werden), die in Nuten (8 bzw. 42) eingesetzt sind, welche an den Innenseiten der Seitenwände (2, 3 bzw. 36, 37) des Gehäuses (1 bzw. 35) vorgesehen sind,
— wobei die Nuten (8 bzw. 42) derart angeordnet sind, dass Frontflächen von Abdeckhauben (14) der Schalter (11) und Anzeigelampen (12) sowie gegebenenfalls Frontflächen von Blinddeckeln (18), Pfeiledeckplatten (48) und Verschlussplatten (21 bzw. 49) mit frontseitigen Seiten-Flanschen (5, 6 bzw. 39, 40) des Gehäuses (1 bzw. 35) bündig sind und eine geschlossene, im wesentlichen ebene Frontfläche des Tableaus bilden.

2. Tableau für Aufzüge, nach Patentanspruch 1, dadurch gekennzeichnet,
— dass die Führungen (9) einen C-profilartigen Querschnitt aufweisen, wobei die Ränder der Montageplatte(n) (10) zangenartig federnd umfasst werden, und
— dass an den Führungen (9) federnde Nocken (33) vorgesehen sind, die auf Stirnseiten (10.1, 10.2) der Montageplatte(n) (10) drücken, so dass diese sowohl in Richtung der Frontseite des Tableaus als auch quer dazu form- und kraftschlüssig gehalten werden,
— wobei die Führungen (9) in den Nuten (8) verschiebbar angeordnet sind, so dass nach Verschieben mindestens einer Führung (9) die Montageplatte(n) (10) von der Frontseite aus eingesetzt oder herausgenommen werden kann (können).

3. Tableau für Aufzüge, nach Patentanspruch 1, dadurch gekennzeichnet, dass die Führungen (43) federnde Rasthebel (44) und eine Auflageleiste (45) aufweisen, so dass beim Einsetzen der Montageplatte(n) (46) von der Frontseite des Tableaus aus, diese mit ihren Rändern in die Führungen (43) einrasten und zwischen den Auflagele-sten (45) und den Rastheblen (44) form- und kraftschlüssig gehalten werden.

4. Tableau für Aufzüge, nach Patentanspruch 3, dadurch gekennzeichnet, dass zwischen den Rasthebeln (44) und den Innenseiten der Seitenwände (36, 37) in Längsrichtung des Tableaus verlaufende und verschiebbare Verriegelungsstangen (47) vorgesehen sind, mittels welchen die Rasthebel (44) blockierbar sind, so dass die Montageplatte(n) (46) nicht entfernt werden kann (können).

5. Tableau für Aufzüge, nach Patentanspruch 1, dadurch gekennzeichnet, dass das Gehäuse (1) aus einem U-Profil besteht, welches die in Längsrichtung des Tableaus verlaufenden Seitenwände (2, 3) und eine Rückwand (4) des Gehäuses (1) bildet, wobei die frontseitigen Seiten-Flansche (5, 6) an den frontseitigen Rändern der Seitenwände (2, 3) angeordnet sind.

**Claims**

1. Control panel, for lifts, with a housing (1 or 35), in which switches (11) and indicator lamps (12), fastened on one or more mounting plates (10 or 46), are arranged for the input of control commands or for the indication of stored control commands, wherein the mounting plate or plates (10 or 46) lying in one plane is or are held by the housing (1 or 35) and wherein the housing (1 or 35) displays two side walls (2, 3 or 36, 37) extending in longitudinal direction of the control panel, characterised thereby,
— that the housing (1 or 35) at the front side of the control panel displays a continuously open face which is larger than the mounting plate or plates (10 or 46) and coverable by covering hoods (14) arranged one placed against the other and
— that the mounting plate or plates (10 or 46) is or are held at their rims in guides (9 or 43), which are inserted in grooves (8 or 42), which are provided at the inward sides of the side walls (2, 3 or 36, 37) of the housing (1 or 35),
— wherein the grooves (8 or 42) are arranged in such a manner that front surfaces of covering hoods (14) of the switches (11) and indicator lamps (12) as well as, in a given case, front surfaces of blank covers (13), arrow cover plates (48) and closure plates (21 or 49) are flush with frontal side flanges (5, 6 or 39, 40) of the housing (1 or 35) and form a closed, substantially planar front surface of the control panel.

2. Control panel for lifts according to claim 1, characterised thereby,

— that the guides (9) display a cross-section in the manner of a C-profile, wherein the rims of the mounting plate or plates (10) are resiliently embraced in the manner of pliers and

— that at the guides (9), there are provided resilient dogs (33), which press on end faces (10.1, 10.2) of the mounting plate or plates (10) so that these are held shape-lockingly and force-lockingly in direction of the front side of the control panel as well as also transversely thereto,

— wherein the guides (9) are displaceably arranged in the grooves (8) so that the mounting plate or plates (10) can be inserted or taken out from the front side after the displacement of at least one guide (9).

3. Control panel for lifts according to claim 1, characterised thereby, that the guides (43) display resilient detent levers (44) and a bearing strip (45), so that on the insertion of the mounting plate or plates (46) from the front side of the control panel, these detent by their rims into the guides (43) and are held shape-lockingly and force-lockingly between the bearing strips (45) and the detent levers (44).

4. Control panel for lifts according to claim 3, characterised thereby, that locking rods (47), which extend and are displaceable in longitudinal direction of the control panel and by means of which the detent levers (44) are blockable so that the mounting plate or plates (46) can not be removed, are provided between the detent levers (44) and the inward sides of the side walls (36, 37).

5. Control panel for lifts according to claim 1, characterized thereby, that the housing (1) consists of a U-profile which forms the side walls (2, 3) extending in longitudinal direction of the control panel and a rear wall (4) of the housing (1), wherein the frontal side flanges (5, 6) are arranged at the frontal rims of the side walls (2, 3).

**Revendications**

1. Tableau de commande pour ascenseur, avec un boîtier (1 ou 35), dans lequel, fixés sur une ou plusieurs plaques de montage (10 ou 46), sont disposés des interrupteurs (11) et des lampes témoin (12) pour respectivement l'introduction d'ordres de commande et la signalisation d'ordres de commande mémorisés, la (les) plaque(s) de montage (10 ou 46), située(s) dans un plan, étant maintenue(s) par le boîtier (1 ou 35) et le boîtier (1 ou 35) comportant deux parois latérales (2, 3 ou 36, 37) s'étendant dans la direction longitudinale du tableau, caractérisé

— en ce qu'au côté frontal du tableau le boîtier (1 ou 35) présente une face avant ouverte de part en part qui est plus grande que la (les) plaque(s) de montage (10 ou 46) et peut être recouverte par des couvercles (14) disposés de manière jointive ainsi que, le cas échéant, par des faux couvercles (18) et/ou par une (des) plaque(s) d'obturation (21 ou 49), et

— en ce que la (les) plaque(s) de montage (10 ou 46) est (sont) maintenue(s) à ses (leurs) bords dans des guides (9 ou 43) montés dans des rainures (8 ou 42) prévues aux côtés intérieurs des parois latérales (2, 3 ou 36, 37) du boîtier (1 ou 35),

— les rainures (8 ou 42) étant disposées de telle manière que des surfaces frontales de couvercles (14) des interrupteurs (11) et lampes témoin (12) ainsi que, le cas échéant, des surfaces frontales de faux couvercles (18), de plaques de recouvrement à flèches (48) et de plaques d'obturation (21 ou 49) sont à fleur de rebords latéraux frontaux (5, 6 ou 39, 40) du boîtier (1 ou 35) et forment une surface frontale fermée et essentiellement plane du tableau.

2. Tableau de commande pour ascenseur selon la revendication 1, caractérisé

— en ce que les guides (9) présentent une section transversale profilée en forme de C, les bords de la (des) plaque(s) de montage (10) étant élastiquement enserrés comme avec une pince, et

— en ce que dans les guides (9) sont prévues des cames (33) faisant ressort qui pressent sur des côtés frontaux (10.1, 10.2) de la (des) plaque(s) de montage (10), de sorte que cette (ces) dernière(s) est (sont) maintenue(s) par conjugaison de formes et de forces tant dans la direction du côté frontal du tableau que transversalement à celle-ci,

— les guides (9) étant disposés déplaçables dans les rainures (8), de sorte qu'après déplacement d'au moins un guide (9) la (les) plaque(s) de montage (10) peut (peuvent) être mise(s) en place ou retirée(s) depuis le côté frontal.

3. Tableau de commande pour ascenseur selon la revendication 1, caractérisé en ce que les guides (43) comportent des leviers à cran (44) faisant ressort et une baguette d'appui (45), de sorte que, lors de la mise en place de la (des) plaque(s) de montage (46) depuis le côté frontal du tableau, celle(s)-ci s'engage(nt) par ses (leurs) bords dans les rainures (43) et est (sont) maintenue(s) par conjugaison de formes et de forces entre les baguettes d'appui (45) et les leviers à cran (44).

4. Tableau de commande pour ascenseur selon la revendication 3, caractérisé en ce qu'entre les leviers à cran (44) et les côtés intérieurs des parois latérales (36, 37) sont prévues des tiges de verrouillage (47) qui s'étendent et sont capables d'être déplacées dans la direction longitudinale du tableau et au moyen desquelles les leviers à cran (44) peuvent être bloqués, de sorte que la (les) plaque(s) de montage (46) ne peut (peuvent) pas être enlevée(s).

5. Tableau de commande pour ascenseur selon la revendication 1, caractérisé en ce que le boîtier (1) consiste en un profilé en U qui forme les parois latérales (2, 3) s'étendant dans la direction longitudinale du tableau et une paroi arrière (4) du tableau, les rebords latéraux frontaux (5, 6) étant disposés aux extrémités frontales des parois latérales (2, 3).

EP 0 190 407 B1

Fig. 2

Fig. 3

Fig. 1

# Fig.4

# Fig.5

# Fig.6

# Fig.8

# Fig.7